Europäisches Patentamt

European Patent Office

Office européen des brevets

(11) Veröffentlichungsnummer: **0 318 850**
**A1**

(12) # EUROPÄISCHE PATENTANMELDUNG

(21) Anmeldenummer: 88119642.2

(22) Anmeldetag: 25.11.88

(51) Int. Cl.4: **C04B 35/00 , H01L 39/12**

Patentansprüche für folgenden Vertragsstaat: ES.

(30) Priorität: 04.12.87 DE 3741107

(43) Veröffentlichungstag der Anmeldung:
07.06.89 Patentblatt 89/23

(84) Benannte Vertragsstaaten:
AT BE CH DE ES FR GB GR IT LI LU NL SE

(71) Anmelder: HOECHST AKTIENGESELLSCHAFT
Postfach 80 03 20
D-6230 Frankfurt am Main 80(DE)

(72) Erfinder: Von Schnering, Hans-Georg, Prof.
Dr.
Theodor-Storm-Weg 7
D-7031 Aidlingen(DE)
Erfinder: Becker, Winfried, Dr.
Am Flachsland 19
D-6233 Kelkheim (Taunus)(DE)
Erfinder: Schwarz, Martin, Dr.
Le Mêle Strasse 26
D-6240 Königstein/Taunus(DE)
Erfinder: Waldschmidt, Elfi
Schulstrasse 42
D-6277 Bad Camberg(DE)
Erfinder: Adam, Joachim
Butzbacher Strasse 14
D-6308 Butzbach(DE)

(54) **Supraleiter und Verfahren zu seiner Herstellung.**

(57) Es werden schwarze Kristallmassen mit der Bruttozusammensetzung $Cu_aSr_bIn_cO_z$ beschrieben, wobei $a+b+c = 1$,
$a/b = 0,5 - 2,5$,
$c = 0,02 - 0,7$ und $z = $ etwa $1 + C/2$.

Diese Massen weisen eine Sprungtemperatur $T_c$ für die Supraleitfähigkeit von über 35 K auf. Sie lassen sich herstellen aus dem Gemisch der Metalloxide in dem angegebenen Atomverhältnis durch Aufheizen auf 800-1000° C.

EP 0 318 850 A1

## Supraleiter und Verfahren zu seiner Herstellung

Die vorliegende Erfindung betrifft hochtemperatursupraleitende Substanzen auf Basis von Indium, Strontium und Kupfer.

Während die konventionellen supraleitenden Materialien ausschließlich bei sehr tiefen Temperaturen eingesetzt werden konnten, die den Einsatz des sehr teuren Kühlmittels Helium erforderten, arbeiten die neuen supraleitenden oxidischen Substanzen bei wesentlich höheren Temperaturen, die mit dem vergleichsweise billigen Kühlmittel Stickstoff erreichbar sind. Hierdurch verringern sich die Betriebskosten supraleitender Geräte und Anlagen und eröffnen neue, umfassende Anwendungsmöglichkeiten.

Ein wesentlicher Nachteil vieler neuer oxidischer Supraleiter besteht allerdings darin, daß sie als eine gemeinsame Komponente La oder Y oder Seltenerdmetalle wie z.B. Sm, Lu, Ho oder Eu enthalten. Diese Metalle kommen zum Teil nur in geringen Mengen vor und sind wegen ihrer aufwendigen Gewinnung teuer. Für die Herstellung großer Mengen oxidischer Supraleiter ergeben sich somit Nachteile aus den hohen Rohstoffpreisen und den begrenzten Resourcen der Seltenerdmetalle.

Es bestand daher die Aufgabe, neue supraleitende oxidische Stoffe bereit zu stellen, die keine seltenen Erdmetalle und kein Lanthan oder Yttrium enthalten und deren Sprungtemperatur deutlich oberhalb 20 K liegt.

Der Erfindung liegt die Erkenntnis zugrunde, daß im Dreistoff-System der Oxide von Indium, Strontium und Kupfer supraleitende Phasen existieren und die Sprungtemperatur günstig beeinflußt wird, wenn in den Kristallmassen, die diese Phasen enthalten, das Atomverhältnis Cu/Sr etwa 0,5 bis 2,5 beträgt.

Es wurden nun neue, in Anspruch 1 näher gekennzeichnete Stoffe mit Supraleitfähigkeit gefunden. Sie bestehen aus den Metallen Strontium, Indium und Kupfer und enthalten diese in oxidischer Form.

Die Substanzen besitzen eine kritische Temperatur (Sprungtemperatur) $T_c$ von über 35 K und sind schwarz.

Die neuen Substanzen stellen Kristallmassen mit der Bruttozusammensetzung $Cu_a Sr_b In_c O_z$ dar, wobei
$a + b + c = 1$,
$a/b = 0,5-2,5$, insbesondere 0,53-2,45,
$c = 0,02$ bis 0,7 und
$z$ etwa $1 + c/2$ ist.
Der minimale Indiumanteil (c) der neuen oxidischen Substanzen beträgt vorzugsweise 5, insbesondere 12 Atom-%. Der maximale Anteil an Indium beträgt vorzugsweise 48, insbesondere 40 Atom-%.

In den Substanzen ist der Sauerstoffgehalt etwas höher als für zweiwertiges Kupfer und dreiwertiges Indium errechnet. Daher enthalten sie wahrscheinlich auch $Cu^{3+}$-Ionen.

Als besonders günstig erwies sich ein Bereich mit $c = 0,12$ bis 0,40 und $a/b = 1:1$ bis 2,4:1. Bei diesem Verhältnis von a/b ist eine besonders günstige Obergrenze für den Indiumanteil (c) 0,35, noch besser 0,32, eine besonders günstige Untergrenze 0,18, noch besser 0,25. Im Bereich von $c = 0,25-0,32$ für den Indiumanteil ist besonders günstig ein Bereich von $a/b = 1,3$ bis 1,9.

Die neuen Substanzen lassen sich dadurch herstellen, daß man Oxide oder Vorläufer der Oxide der Elemente Indium, Strontium und Kupfer gründlich vermischt, das Gemisch auf Temperaturen von 800 bis 1100 °C aufheizt und längere Zeit in diesem Temperaturbereich hält. Während der Reaktion ändert sich das Atomverhältnis der eingesetzten Metalle in erster Nährung nicht. Das verwendete Atomverhältnis entspricht daher der angestrebten Oxidzusammensetzung.

Als Oxidvorläufer lassen sich allgemein Verbindungen einsetzen, die unter den Bedingungen des Erhitzens auf 800-1100 °C zu den entsprechenden Oxiden reagieren, insbesondere die Hydroxide und Nitrate. Als günstig erweist sich ferner die Herstellung aus Acetaten, Formiaten, Oxalaten sowie Carbonaten der genannten Metalle. Verwendbar ist z.B. Strontiumcarbonat, $Cu_2O$ und CuO. Die Sythesetemperatur liegt vorzugsweise im Bereich von 800 bis 1050 °C, vorzugsweise 900 bis 1000 °C. Die Reaktionszeit soll mindestens 4 Stunden, noch besser mindestens 6 Stunden betragen. Nach oben wird die Reaktionszeit nur durch wirtschaftliche Überlegungen begrenzt. Die eigentliche Reaktion soll in einer nicht-reduzierenden Atmosphäre stattfinden. Verwendbar sind z.B. Luft, Stickstoff, reiner Sauerstoff oder Gemische von $O_2/Ar$. Es ist bevorzugt, insbesondere bei Verwendung von Cu-I-Verbindungen wenn die Umsetzung der Oxide in einer Sauerstoff enthaltenden Atmosphäre durchgeführt wird. Die Anwendung erhöhter Sauerstoffdrucke scheint keine Vorteile zu bieten. Mit fortschreitender Reaktion nimmt die Anzahl der Linien im Röntgenbeugungsspektrum ab. Die Reaktion ist daher beendet, wenn keine Änderung des Spektrums mehr eintritt. Die Abkühlungsgeschwindigkeit, mit der die Probe von der Reaktionstemperatur auf Raumtemperatur abgekühlt wird, ist nicht unwesentlich. Falls die Abkühlungsgeschwindigkeit bei 400 °C/h oder niedriger liegt, ist keine weitere Nachbehandlung erforderlich. Bei höheren Abkühlungsgeschwindigkeiten ist es vorteilhaft, bei niedrigeren Abkühlungsgeschwindigkeiten möglich, die abgekühlte Probe zusätzlich bei Temperaturen zwischen 300 und 600 °C mehrere Stunden zu erhitzen. Die Dauer dieses Erhitzens beträgt mindestens 2 Stunden, vorzugsweise mindestens 4 Stunden. Längeres Erhitzen als 20 Stunden bringt keine Vorteile. Vorzugsweise findet dieses Erhitzen zwischen 350 und 550 °C, insbesondere bei 390 bis 420 °C statt. Wie bei der eigentlichen Reaktion ist es vorteilhaft, das Abkühlen und das Erhitzen ebenfalls in einer Sauerstoff enthaltenden Atmosphäre durchzuführen. Wenn das erste Erhitzen in Abwesenheit von $O_2$ durchgeführt wurde, ist ein zweites Erhitzen in Gegenwart von $O_2$ obligatorisch.

Um sicherzustellen, daß sich das gesamte Oxidgemisch umgesetzt hat, ist es vorteilhaft, das erhaltene Pulver nach dem Abkühlen und vor dem nachträglichen Erhitzen zu zermahlen. Als Reaktionsgefäße können handelsübliche Tiegel oder Schiffchen aus inerten Materialen wie z.B. Aluminumoxid, Zirkon, Platin und Iridium benutzt werden. Als Wärmequelle eigenen sich handelsübliche Öfen, wie z.B. Kammer-, Muffel-oder Rohröfen.

Ein weiteres Verfahren zur Herstellung der supraleitenden Substanzen besteht darin, daß man Salze von In, Sr und Cu in Gegenwart einer wäßrigen Phase vermischt, das wasserhaltige Salzgemisch eindampft und im Temperaturbereich von 800 bis 1100 °C, vorzugsweise 900 bis 1000 °C längere Zeit erhitzt. Mindestens eines der eingesetzten Salze soll wasserlöslich sein und die Salze sollen sich im angegebenen Temperaturbereich zu den Oxiden zersetzen. Hinsichtlich der Reaktionszeit gilt das gleiche wie bei Verwendung der Oxide.

Das einzudampfende Salzgemisch läßt sich auch dadurch herstellen, daß man die Metalloxide in Salpetersäure löst und die Salpetersäure abraucht.

Man kann auch, soweit wasserlösliche Salze eingesetzt werden, durch Kopräzipitation mit Hilfe einer Base, z.B. Tetramethylammonium-Hydroxid, die Metallhydroxide ausfällen. Auf diese Weise gelingt es, ein besonders innig vermischtes Ausgangsprodukt zu erhalten. Die ausgefällten Hydroxide können abgetrennt, getrocknet und dann wie oben angegeben längere Zeit erhitzt werden. Vorzugsweise werden durch die verwendete Base keiner schwer flüchtigen Kationen und durch die eingesetzen Salze keine schwer flüchtigen Anionen eingeschleppt.

Auch bei dieser Ausgestaltung des erfindungsgemäßen Verfahrens entspricht das Atomverhältnis der eingesetzten Metallsalze dem engestrebten Atomverhältnis des Endproduktes. Die aus den Salzen hergestellten oxidischen Produkte lassen sich, wie oben beschrieben ebenfalls thermisch nachbehandeln.

Überraschenderweise lassen sich beim erfindungsgemäßen Verfahren aus Laborchemikalien mit einer Reinheit von nur etwa 99,5 % supraleitende Substanzen gewinnen. Verwendbar sind aber auch Chemikalien mit einem Reingehalt von 99,8, 99,9 oder 99,99 %.

Die gewonnenen supraleitenden Substanzen lassen sich in der Energietechnik (für Kabel und Drähte, Transformatoren, und Energiespeicher in Form stromdurchflossener Spulen), in der Magnettechnologie (z.B. für Kernspintomographen und zur Herstellung von Haltemagneten für Schwebebahnnen), in der Computertechnik (dünne Schichten, Verbindungen auf Leiterplatten, Josephson-Schaltelemente) und für elektronische Bauelemente (Detektoren, Antennen, Transistoren, elektronische Sensoren, z.B. SQUIDS, Galvanometer, Modulatoren, Bolometer und SLUGs) verwenden. Die Anwendung der Supraleitung in der Meßtechnik wird behandelt in dem gleichnamigen Aufsatz von Prof. F. Baumann, Karlsruhe, in einer Aufsatzreihe des VDI-Bildungswerkes (1976).

Die Erfindung wird durch die Beispiele näher erläutert.

**Beispiel 1**

1,8 mol $SrC_2O_4$, 1 mol $In_2O_3$ und 3 mol CuO werden in einem Achatmörser zerkleinert, gründlich gemischt und in einen Tiegel aus $Al_2O_3$ überführt. Die Probe wird an Luft in einem geeigneten Laborofen schnell auf 1000 °C erhitzt und dort 10 h gehalten, anschließend innerhalb von 10 h auf Raumtemperatur abgekühlt. Das Produkt, bestehend aus einem schwarzen, krümeligen Pulver mit einer Dichte von 6,20 g/cm³ (Pyknom.), wird mit einem Druck von etwa 300 MPa (3 kbar) zu Tabletten gepreßt. Messungen mit einem SQUID- oder Quanteninterferometer ergaben, daß das so hergestellte Material eine supraleitende Phase mit einer kritischen Temperatur $T_c$ ungefähr 42 K enthielt. Aus der Stärke des Meißner-Effekts ist abzuschätzen, daß der Anteil dieser Phase 1-50 Vol.-% beträgt.

**Beispiel 2**

1,8 mol $SrC_2O_4$, 0,5 mol $In_2O_3$ und 1,5 mol $Cu_2O$ werden in einem Achatmörser zerkleinert, gründlich gemischt und in einen Tiegel aus $Al_2O_3$ überführt. Die Probe wird unter Argon in einem Laborofen innerhalb von 1 h auf 900 °C erhitzt, 12 h bei 900 °C gehalten und in 1 h auf Raumtemperatur abgekühlt. Das so erhaltene schwarze Pulver wird in einem Achatmörser zerkleinert und unter einem Druck von etwa 300 MPa (3 kbar) zu Tabletten gepreßt. Das gepreßte Material wird abermals in 1 h auf 900 °C erhitzt, bei dieser Temperatur 12 h gehalten und in 1 h auf Raumtemperatur abgekühlt, wobei diese zweite Stufe unter Sauerstoff durchgeführt wird. Messungen an den schwarzen Tabletten mit einem SQUID- oder Quanteninterferometer ergaben, daß das so hergestellte Material eine supraleitende Phase enthielt, deren Anteil etwa 1 bis 50 Vol.-% und deren kritische Temperatur ungefähr 42 K beträgt.

## Ansprüche

1. Schwarze Kristallmasse der allgemeinen Formel
$Cu_aSr_bIn_cO_z$, wobei
$a+b+c = 1$,
$a/b = 0,5$-$2,5$, insbesondere $0,53$-$2,45$,
$c = 0,02$ - $0,7$ und
$z$ etwa $1+c/2$
ist, mit einer Sprungtemperatur für die Supraleitfähigkeit von $>35$ K.

2. Masse gemäß Anspruch 1, dadurch gekennzeichnet, daß $c = 0,12$-$0,40$ ist.

3. Masse gemäß Anspruch 2, dadurch gekennzeichnet, daß $a/b = 1$ bis $2,4$ ist.

4. Masse gemäß Anspruch 3, dadurch gekennzeichnet, daß $c = 0,18$-$0,25$ ist.

5. Masse gemäß Anspruch 4, dadurch gekennzeichnet, daß $a/b = 1,3$-$1,9$ ist.

6. Verfahren zur Herstellung eines supraleitenden Produktes, dadurch gekennzeichnet, daß man ein Gemisch der Oxide von Indium, Strontium und Kupfer oder entsprechende Oxidvorläufer vermischt, das Gemisch auf Temperaturen von 800 bis 1100 °C aufheizt und längere Zeit in diesem Temperaturbereich hält, wobei das Atomverhältnis der eingesetzten Oxide oder Oxidvorläufer dem in Anspruch 1 angegebenen Verhältnis entspricht.

7. Verfahren zur Herstellung eines supraleitenden Produktes, wobei man Salze von Indium, Strontium und Kupfer, die thermisch zu den Oxiden zersetzbar sind und von denen mindestens eines wasserlöslich ist, in Gegenwart einer wäßrigen Phase vermischt, das Gemisch eindampft und längere Zeit auf 900 bis 1100 °C erhitzt, wobei das Atomverhältnis der eingesetzten Salze dem in Anspruch 1 angegebenen Verhältnis entspricht.

8. Verfahren nach Anspruch 7, dadurch gekennzeichnet, daß man durch Zugabe einer Base zu dem Gemisch der Salze in Gegenwart eines wäßrigen Phase mindestens ein Metallhydroxid ausfällt, den unlöslichen Anteil abtrennt, trocknet und bei Temperaturen von 800 bis 1100 °C längere Zeit erhitzt.

9. Verfahren nach Anspruch 8, dadurch gekennzeichnet, daß die eingesetzten Salze sich von leicht flüchtigen Säuren ableiten.

10. Verfahren nach Anspruch 6 oder 7, dadurch gekennzeichnet, daß man die zunächst gewonnene Kristallmasse zerkleinert und in einem Temperaturbereich von 300 bis 600 °C erneut für längere Zeit erhitzt.

11. Verfahren nach einem der Ansprüche 6 bis 10, dadurch gekennzeichnet, daß man in einer Atmosphäre erhitzt, die freien Sauerstoff enthält.

12. Produkt erhältlich nach dem Verfahren gemäß Anspruch 6.

Patentansprüche für folgenden Vertragsstaat: ES

1. Verfahren zur Herstellung eines supraleitenden Produktes mit einer Sprungtemperatur $T_c$ von über 35K, dadurch gekennzeichnet, daß man ein Gemisch der Oxide von Indium, Strontium und Kupfer oder entsprechende Oxidvorläufer vermischt oder thermisch zersetzbare Salze dieser Elemente, von denen mindestens eines wasserlöslich ist, in Gegenwart einer wäßrigen Phase vermischt und das Gemisch eindampft, den Ansatz auf Temperaturen von 800 bis 1100 °C aufheizt und längere Zeit in diesem Temperaturbereich hält, wobei die eingesetzten Oxide oder Oxidvorläufer bezogen auf den Metallanteil 2-70 Atom-% Indium enthalten und das Atomverhältnis Kupfer/Strontium = 0.5:1-2.5:1, insbesondere 0.53:11-2.45:1 beträgt.

2. Verfahren nach Anspruch 1, dadurch gekennzeichnet, daß das eingesetzte Gemisch 12-40 Atom-% Indium enthält.

3. Verfahren nach Anspruch 2, dadurch gekennzeichnet, daß ein eingesetztes Gemisch, das das Atomverhältnis Kupfer/Strontium 1:1-2.4:1 beträgt.

4. Verfahren nach Anspruch 3, dadurch gekennzeichnet, daß das eingesetzte Gemisch 18-25 Atom-% Indium enthält.

5. Verfahren nach Anspruch 4, dadurch gekennzeichnet, daß ein eingesetztes Gemisch das Atomverhältnis Kupfer/Strontium 1.3:1-1.9:1 beträgt.

6. Verfahren nach Anspruch 1, dadurch gekennzeichnet, daß man ein Gemisch der Salze von Cu, Sr und In in Gegenwart einer wäßrigen Phase einsetzt, hierzu ein Base gibt und so mindestens ein Metallhydroxid ausfällt, man den unlöslichen Anteil abtrennt, trocknet und bei Temperaturen von 800 bis 1100 °C längere Zeit erhitzt.

7. Verfahren nach Anspruch 1, dadurch gekennzeichnet, daß die eingesetzten Salze von Cu, Sr und In sich von leicht flüchtigen Säuren ableiten.

8. Verfahren nach Anspruch 1, dadurch gekennzeichnet, daß man die zunächst gewonnene Kristallmasse zerkleinert, und in einem Temperaturbereich von 400 bis 900°C erneut für längere Zeit erhitzt.

9. Verfahren nach Anspruch 1 oder 8, dadurch gekennzeichnet, daß man in einer Atmosphäre erhitzt, die freien Sauerstoff enthält.

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| X,P | EP-A-0 283 024 (SUMITOMO ELECTRIC INDUSTRIES LTD) * Ansprüche 1,2,15,19; Spalte 2, Zeilen 17-39 * | 1,6 | C 04 B 35/00 H 01 L 39/12 |
| Y | | 7-12 | |
| A | | 2-5 | |
| | --- | | |
| X,P | EP-A-0 284 061 (SUMITOMO ELECTRIC INDUSTRIES LTD) * Ansprüche 1-4; Spalte 4, Zeilen 8-49 * | 1,6 | |
| Y | | 7-12 | |
| A | | 2-5 | |
| | --- | | |
| Y | ADVANCED CERAMIC MATERIALS, Special Supplementary Issue, Band 2, Nr. 3B, Juli 1987, Seiten 539-555, American Ceramic Society Publication US; E.C. BEHRMAN et al.: "Synthesis, characterization, and fabrication of high temperature superconducting oxides" * Seite 540 * | 7-12 | |
| | --- -/- | | |

**RECHERCHIERTE SACHGEBIETE (Int. Cl.4)**

C 04 B
H 01 L

Der vorliegende Recherchenbericht wurde für alle Patentansprüche erstellt

| Recherchenort | Abschlußdatum der Recherche | Prüfer |
|---|---|---|
| DEN HAAG | 09-03-1989 | LUETHE H. |

KATEGORIE DER GENANNTEN DOKUMENTE

X : von besonderer Bedeutung allein betrachtet
Y : von besonderer Bedeutung in Verbindung mit einer
anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder
nach dem Anmeldedatum veröffentlicht worden ist
D : in der Anmeldung angeführtes Dokument
L : aus andern Gründen angeführtes Dokument
······································································································
& : Mitglied der gleichen Patentfamilie, übereinstimmendes
Dokument

EPO FORM 1503 03.82 (P0403)

**Europäisches Patentamt**

# EUROPÄISCHER RECHERCHENBERICHT

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| Y | ADVANCED CERAMIC MATERIALS, Special Supplementary Issue, Band 2, Nr. 3B, Juli 1987, Seiten 444-456, American Ceramic Society Publication, US; G.W. CRABTREE et al.: "Fabrication, mechanical properties, heat capacity, oxygen diffusion, and the effect of alkali earth ion substitution on high Tc superconductors" * Seiten 444,445 * | 7-12 | |
| | | | RECHERCHIERTE SACHGEBIETE (Int. Cl.4) |

Der vorliegende Recherchenbericht wurde für alle Patentansprüche erstellt

| Recherchenort | Abschlußdatum der Recherche | Prüfer |
|---|---|---|
| DEN HAAG | 09-03-1989 | LUETHE H. |

EPO FORM 1503 03.82 (P0403)